# DEMANDE DE BREVET EUROPEEN

(11) **EP 1 096 035 A1**
(43) Date de publication de la demande: **02.05.2001**
(21) Numéro de dépôt: 00402967.4
(22) Date de dépôt: 25.10.2000
(51) Int. Cl.: C23C 14/02, C23C 28/02, C23C 14/56

(54) **Tôle d'acier revêtue et procédé et appareil de fabrication de cette tôle**

(30) Priorité: 26.10.1999 FR 9913327
(71) Demandeur: USINOR, 92800 Puteaux (FR)
(72) Inventeur: Chaleix, Daniel, 57220 Boulay (FR); Choquet, Patrick, 57050 Longeville-les-Metz (FR); Lamande, Alain, 57000 Metz (FR); Scott, Colin, 57000 Metz (FR); Olier, Christophe, 54000 Nancy (FR)
(74) Mandataire: Neyret, Daniel

(57) **Abrégé**

Tôle d'acier dotée d'un revêtement comprenant une couche principale d'alliage zinc-chrome, dont la phase prépondérante présente une structure δ et/ou ζ, caractérisée en ce que ledit revêtement comprend également une couche sous-jacente d'adhérence en alliage zinc-chrome, intercalée entre l'acier de la tôle et ladite couche principale, qui présente:
- une structure cristalline cubique centré de type Γ,
- une teneur pondérale en chrome suffisamment élevée pour obtenir ladite structure Γ,
- une jonction au moins partielle d'épitaxie avec ledit acier.

L'invention concerne également les installations d'obtention en continu de revêtements d'alliages, comportant essentiellement deux éléments métalliques, sur une tôle, et, plus particulièrement, les revêtements d'alliage Zn-Cr, par un procédé de dépôt sous vide de ses éléments, dans laquelle on fait défiler en continu ladite tôle (12) successivement devant une source du premier élément métallique d'alliage (1) puis devant une source du second élément d'alliage (2) métallique.

## Description

L'invention concerne les tôles d'acier dotées d'un revêtement comprenant une couche principale d'alliage zinc-chrome, dont la phase prépondérante est δ ou ζ.

L'invention concerne également l'installation et le procédé d'obtention de tôles d'acier revêtues d'un revêtement de ce type d'alliage.

Le document EP 0 607 452 (KAWASAKI) décrit les phases cristallines que l'on peut obtenir en déposant par électrodéposition des revêtements monocouche d'alliages Zn-Cr et les principales propriétés associées à ces phases ; selon les proportions respectives de zinc et de chrome, selon les conditions d'électrodéposition, on distingue ainsi les principales phases suivantes d'alliage :
- η de structure hexagonale identique à celle du zinc pur, où le chrome est en solution solide en faibles proportions ;
- δ également de structure hexagonale dont le paramètre de maille a est supérieur à celui de la structure η, dont le paramètre de maille c est inférieur à celui de la structure η ;
- Γ de structure cubique centré dont le paramètre de maille est supérieur à celui du chrome pur.

Le document JP 08-013192 A (KAWASAKI) enseigne que le recuit d'une couche d'alliage zinc-chrome dont la phase est δ transforme la structure de cette couche ; dans des conditions de traitement qui varient selon le taux de chrome, la durée et la température du recuit (130°C à 200°C), on obtient ainsi une phase :
- ζ de structure monoclinique.

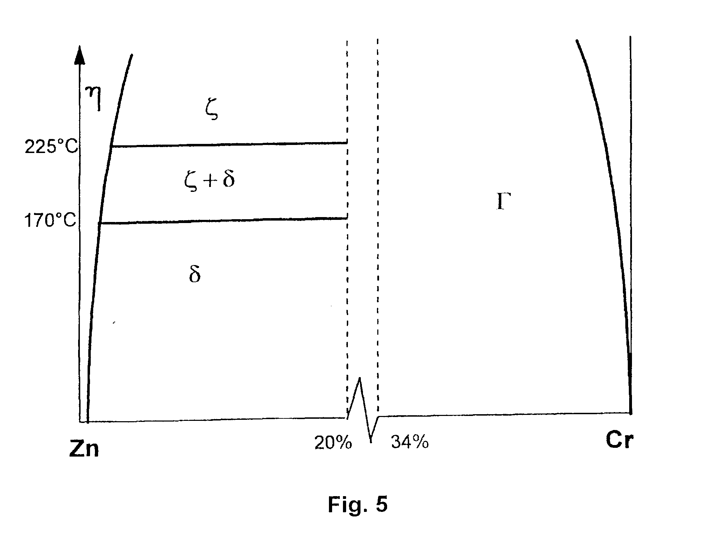

La figure 5 présente le diagramme, établi par la demanderesse, de la synthèse des essais d'identification et de stabilité thermique des phases des alliages Zn-Cr en fonction de la teneur en chrome (%), dans le cas particulier de dépôts réalisés sous vide par « PVD » (Physical Vapor Deposition en langue anglaise).

A la page 9, lignes 57-58 du document EP 0 607 452, on indique qu'en deçà de 5% de teneur pondérale en chrome dans l'alliage, on ne formera pas de phase Γ dans le revêtement, et que au delà de 30% de chrome, le revêtement obtenu ne présente pas une bonne adhérence sur l'acier.

Cette indication dissuade donc d'utiliser des teneurs élevées en chrome, supérieures à 30%, notamment à l'interface entre l'acier et le revêtement, pour éviter de détériorer l'adhérence.

Conformément à cette divulgation selon laquelle une couche d'alliage zinc-chrome adhère mal à l'acier si l'interface entre cette couche et le substrat est trop riche en chrome, on a effectivement constaté que les couches d'alliage zinc-chrome à gradient, préparées sous vide, présentant une concentration en chrome de 15% environ à l'interface et de 5% environ en surface, posaient des problèmes d'adhérence sur le substrat d'acier ; en pliant à 180° une tôle d'acier revêtue d'une telle couche, on observe en effet un décollement partiel de la couche d'alliage.

L'invention a pour but de remédier à cet inconvénient.

A cet effet l'invention a pour objet une tôle d'acier dotée d'un revêtement comprenant une couche principale d'alliage zinc-chrome, dont la phase prépondérante présente une structure δ et/ou ζ, caractérisée en ce que ledit revêtement comprend également une couche sous-jacente d'adhérence en alliage zinc-chrome, intercalée entre l'acier de la tôle et ladite couche principale, qui présente :
- une structure cristalline cubique centré de type Γ,
- une teneur pondérale en chrome suffisamment élevée pour obtenir ladite structure Γ,
- une jonction au moins partielle d'épitaxie avec ledit acier, manifestée par la présence d'anneaux incomplets sur un diagramme de diffraction électronique de ladite sous-couche réalisé sur des coupes pratiquées au voisinage de l'interface avec l'acier, parallèlement à cette interface.

L'invention peut également présenter une ou plusieurs des caractéristiques suivantes :
- la teneur pondérale en chrome dans ladite couche sous-jacente est comprise entre 30 et 70%.
- l'épaisseur de ladite couche sous-jacente est comprise entre 0,01 µm et 1 µm.
- l'épaisseur de ladite couche principale est supérieure à 1 µm ; en effet, la rugosité du substrat est souvent de l'ordre de 1 µm et parfois supérieure ; pour que le revêtement apporte une protection efficace contre la corrosion et une bonne résistance à la rouille rouge, il importe que le revêtement soit suffisamment couvrant et que son épaisseur soit supérieure à la rugosité du substrat.
- ladite couche principale est une couche à gradient de concentration de chrome; de préférence, la variation de concentration de chrome dans l'épaisseur de ladite couche principale est supérieure ou égale à 10% en poids.

La concentration de chrome dans ladite couche principale peut être plus élevée au voisinage de la surface qu'au voisinage de l'acier ; de préférence, afin d'obtenir à la fois une protection efficace contre la corrosion et une bonne phosphatabilité, la concentration de chrome dans ladite couche principale est plus élevée au voisinage de l'acier qu'au voisinage de la surface.
- la phase prépondérante de la couche principale présente une structure ζ.
- la couche principale du revêtement peut ne présenter que partiellement une structure ζ ; notamment, si on soumet le revêtement à un rayonnement X sous incidence rasante de l'ordre de 3°, ledit rayonnement provenant d'un tube à rayons X à anti-cathode de cobalt alimenté sous 30kV et débitant 30mA, émettant une raie de longueur d'onde Ka = 0,179026 nm, et si l'on analyse la diffraction de ce rayonnement à l'aide d'un monochromateur arrière et d'un détecteur à scintillations, la hauteur de la raie de diffraction (131) de la phase ζ-ZnCr reste comprise entre 10% et 100% environ de la hauteur de la raie (0002) de la phase δ-ZnCr.

L'invention a également pour objet un procédé de fabrication d'une tôle selon l'invention à partir d'une tôle à revêtir, caractérisé en ce qu'il comprend une étape dans laquelle ledit revêtement est appliqué par dépôt sous vide sur la surface de ladite tôle à revêtir.

L'invention peut également présenter une ou plusieurs des caractéristiques suivantes :
- ledit revêtement est appliqué par évaporation et/ou sublimation sous vide de zinc et de chrome.
- ladite tôle à revêtir est portée pendant le dépôt à une température comprise entre 170°C et 230°C environ.
- immédiatement avant l'étape de dépôt, on nettoie et/ou on avive ladite surface d'une manière adaptée pour obtenir ladite jonction au moins partielle d'épitaxie, de préférence par bombardement d'ions de gaz neutre.

L'invention concerne également les installations d'obtention en continu de revêtements d'alliages, comportant essentiellement deux éléments métalliques, sur une tôle, et, plus particulièrement, les revêtements d'alliage Zn-Cr, par un procédé de dépôt sous vide de ces éléments, dans laquelle on fait défiler en continu ladite tôle successivement devant une source du premier élément métallique d'alliage puis devant une source du second élément d'alliage métallique.

Le mot « source » dans ce texte peut désigner une source d'évaporation, ou un source de sublimation qui peut être chauffée par bombardement électronique, conduction (résistance ou induction), radiation ou par plasma .

Dans un tel procédé, lorsque le débit de vapeur émis par la source métallique est faible (< 1g/mn.cm²), le gradient de pression de la vapeur métallique au dessus de la source est faible, les atomes métalliques évaporés ou sublimés subissent de ce fait très peu de collisions. On peut donc considérer que la propagation de la grande majorité des atomes entre la source et le substrat s'effectue en ligne droite.

En revanche, si le débit de vapeur émis par la source métallique est fort (> 1g/mn.cm²), le gradient de pression de la vapeur métallique au dessus de la source est fort, une grande majorité des atomes métalliques qui vont quitter la source vont subir plusieurs collisions avant d'atteindre le substrat. La dispersion de l'élément métallique sur le substrat sera d'autant plus importante que le débit de vapeur est fort.

On sait, qu'en disposant un écran entre la source et le substrat vu de cette source sous un angle solide donné, une partie de la vapeur émise dans cette angle solide est arrêtée par cet écran et ne se condense plus sur le substrat. Si le débit de vapeur est faible et si la pression résiduelle dans la chambre de dépôts est faible, comprise entre 10⁻⁴ et 10⁻¹ Pa, c'est la quasi-totalité de la vapeur qui sera arrêtée.

Lorsqu'une bande à revêtir défile successivement devant une source d'évaporation ou de sublimation d'un premier élément d'alliage A puis devant une source d'évaporation ou de sublimation d'un second élément d'alliage B, tel que décrit par exemple dans le document JP 06 212410 A (ISHIKAWAJIMA HARIMA HEAVY IND Ltd), la couche d'alliage obtenue n'est pas homogène en composition dans la profondeur : plus riche en élément A près du substrat qu'en surface, plus riche en élément B en surface que près du substrat ; la couche d'alliage obtenue est qualifiée de couche « à gradient ».

Le document JP 03-191053 (KOBE STEEL) divulgue un revêtement ZnCr à gradient sur une tôle d'acier, dans lequel la concentration en chrome à l'interface avec le substrat est supérieure à 10% alors qu'elle est inférieure à 5% en surface externe ; un tel revêtement apporte à la fois une résistance importante à la corrosion grâce à la concentration élevée en chrome dans la profondeur et une bonne aptitude à la phosphatation grâce à la faible concentration en chrome en surface.

Pour obtenir un tel revêtement ZnCr à gradient à l'aide du procédé précité, plus riche en chrome du côté du substrat qu'en surface, il convient de faire défiler la bande à revêtir d'abord devant la source de chrome, puis devant la source de zinc ; de manière générale, pour obtenir un revêtement d'alliage AB à gradient, plus riche en élément A du côté du substrat qu'en surface, il convient de faire défiler le substrat d'abord devant la source A, puis devant la source B.

Les installations de dépôt sous vide comportent :
- des moyens de défilement de tôle ou d'une bande de tôle,
- une chambre d'évaporation et/ou de sublimation ouverte sur une fenêtre d'évaporation et/ou de sublimation débouchant sur une zone du chemin de défilement de la tôle,
- au moins une source d'éléments à déposer disposée dans cette chambre de manière à émettre au travers de la fenêtre.

L'angle solide utile d'émission d'une source est en général délimité par cette fenêtre ; il rassemble les trajectoires possibles d'éléments susceptibles de se condenser sur le substrat.

Dans les installations de dépôt comprenant une source d'élément A et une source d'élément B pour la réalisation d'un revêtement comprenant une couche d'alliage AB, les sources A et B sont disposées dans la même chambre de manière à émettre au travers de la même fenêtre ; si les sources A et B sont disposées à la même distance de cette fenêtre, l'angle utile d'émission de chaque élément est identique.

Dans le cas des installations adaptées pour la réalisation de couches à gradient où la bande à revêtir défile successivement d'abord devant une source A puis devant une source B émettant au travers de la même fenêtre, le document JP 06 212410 A déjà cité décrit l'utilisation d'écrans, « caches » ou « diaphragmes » pour obtenir des revêtements multicouches comprenant une couche d'alliage AB à gradient et une couche d'élément A pur et/ou une couche d'éléments B pur.

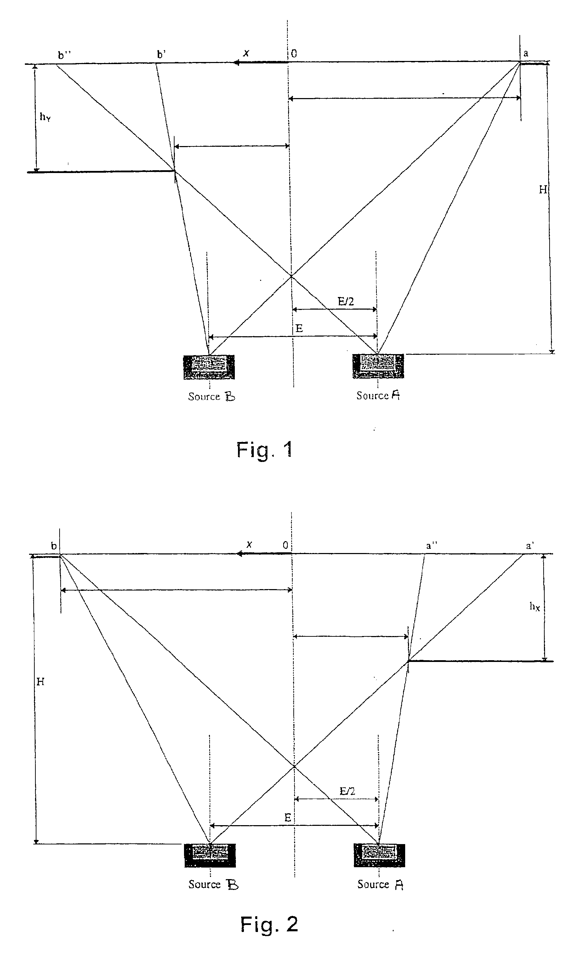

On va maintenant décrire des procédés d'obtention de tels revêtements multicouches à l'aide de ces installations en se référant aux figures 1 à 3 ; la flèche x indique le sens de défilement du substrat à revêtir.

La fenêtre au travers de laquelle la source A et la source B émettent présentent deux bords ; ces bords sont réglables en position (soit en hauteur et/ou latéralement), et forment ainsi des diaphragmes ; le bord qui est situé du côté de la source A est appelé « bord d'entrée A » et le bord qui est situé du côté de la source B est appelé « bord de sortie B ».

En se référant à la figure 2, si le bord d'entrée A est disposé à distance hₓ du chemin de défilement de la bande (et non pas à proximité), en entrée de la zone de dépôt a'a", il se déposera majoritairement l'élément B, et on obtiendra un revêtement bicouche de type -B(+A)-AB, où la sous-couche B(+A) aura une teneur en A qui sera fonction principalement du débit de vapeur de la source et de la pression résiduelle dans la chambre de dépôts, et où la couche AB est plus riche en élément A du côté du substrat qu'en surface. Dans un souci de simplification, on parlera ultérieurement de revêtement -B-AB pour décrire un revêtement de type -B(+A)-AB.

Si l'on inverse le sens de défilement de la bande, on obtient alors un revêtement bicouche de type -AB-B(+A), où la sous-couche AB est plus riche en élément B du côté du substrat qu'en surface.

En se référant à la figure 1, si le bord de sortie B est disposé à distance h_{y} du chemin de défilement de la bande (et non pas à proximité), en sortie de la zone de dépôt b'b", il se déposera majoritairement l'élément A, et on obtiendra un revêtement bi-couche de type -AB-A(+B) (ou plus simplement -AB-A), où la couche A(+B) aura une teneur en B qui sera fonction principalement du débit de vapeur de la source et de la pression résiduelle dans la chambre de dépôts, et où la sous-couche AB est plus riche en élément A du côté du substrat qu'en surface.

Si l'on inverse le sens de défilement de la bande, on obtient alors un revêtement bicouche de type -B(+A)-AB, où la couche AB est plus riche en élément B du côté du substrat qu'en surface.

On voit donc, que dans le sens de défilement de la bande tel qu'indiqué aux figures 1 et 2, une telle disposition des bords de la fenêtre utile d'émission des éléments A et B permet de réaliser des revêtements bi-couches de type -B- AB, -AB-A ; en associant les deux dispositions de bords A et B comme illustré à la figure 3, on obtient des revêtements -B-AB-A, où la couche AB est toujours plus riche en élément A du côté du substrat qu'en surface.

L'effet direct d'une telle disposition des bords A et/ou B, qui consiste à les mettre à distance hₓ et/ou h_{y} du chemin de défilement de la tôle, est d'élargir les deux angles solides utiles d'émission d'élément A et d'élément B ; la mise à distance hₓ du bord d'entrée A élargit davantage l'angle utile d'émission d'élément B dont la source est plus éloignée, que celui d'élément A, dont la source est plus proche, et conduit donc à la formation d'une couche d'élément B sous la couche d'alliage AB ; la mise à distance h_{y} du bord de sortie B élargit davantage l'angle utile d'émission d'élément A dont la source est plus éloignée, que celui d'élément B, dont la source est plus proche, et conduit donc à la formation d'une couche d'élément A sur la couche d'alliage AB ; de manière générale, la mise à distance d'un bord élargit davantage l'angle utile d'émission d'élément dont la source est la plus éloignée et conduit donc à la formation d'une couche pure (ou dans la majorité des cas, peu allié) de cet élément au dessus ou en dessous de la couche d'alliage AB ; l'effet est d'autant plus prononcé que la distance entre les sources est importante.

L'invention a pour but de réaliser, outre les revêtements proposés par le document JP 06 212410 A, des revêtements de type A-AB-A ou B-AB-B, où la couche AB est toujours plus riche en élément A du côté du substrat qu'en surface si la bande défile de la source A vers la source B.

Bien évidemment si le sens de la bande est inversée, on peut obtenir les mêmes types de revêtements que précédemment, mais dans ce cas la couche AB devient plus riche en élément B du côté du substrat qu'en surface.

A cet effet l'invention a pour objet une installation de revêtement pour l'obtention d'une tôle selon les revendications 1 à 10, susceptible d'être utilisée au moins dans l'étape d'application du revêtement du procédé selon l'une quelconque des revendications 11 à 15, comprenant, si A désigne le chrome et si B désigne le zinc :
- un dispositif de défilement de la tôle à revêtir face à une fenêtre d'évaporation ou de sublimation d'élément A et/ou B,
- une source d'évaporation ou de sublimation d'élément A et une source d'évaporation ou de sublimation d'élément B disposés successivement sur une direction parallèle à celle dudit défilement et dans le sens de ce défilement, de manière à émettre au travers de la même fenêtre selon un angle utile d'émission limité par ladite fenêtre, la tôle à revêtir défilant d'un bord d'entrée vers un bord de sortie de ladite fenêtre, caractérisée en ce qu'elle comprend des moyens pour diminuer l'angle d'émission de la source d'élément B en deçà de la limite représentée par le bord d'entrée, lesdits moyens pour diminuer l'angle d'émission de la source étant montés mobiles en translation perpendiculaire au défilement de la tôle, leur position pouvant varier entre la source d'élément A et la source d'élément B de manière à obtenir soit le revêtement de type -A-AB-A, soit de type -B-AB-B.

L'invention peut également présenter les caractéristiques suivantes :
- l'installation comprend également des moyens pour diminuer l'angle d'émission de la source d'élément A en deçà de la limite représentée par le bord de sortie, la position desdits moyens pouvant varier entre la source d'élément A et la source d'élément B de manière à obtenir soit le revêtement de type -A-AB-A, soit de type -B-AB-B.
- lesdits moyens pour diminuer l'angle d'émission sont formés par au moins un écran disposé entre la source d'élément A et la source d'élément B , la position desdits moyens pouvant varier entre la source d'élément A et la source d'élément B de manière à obtenir soit le revêtement de type -A-AB-A, soit de type -B-AB-B.

Dans le cas particulier des revêtements d'alliage Zn-Cr, en diminuant l'angle d'émission de la source d'élément Cr en deçà de la limite représentée par le bord de sortie, on obtient une couche superficielle encore plus riche en zinc, ce qui est favorable à la phosphatabilité.

En revanche en diminuant l'angle d'émission de la source d'élément Zn en deçà de la limite représentée par le bord de sortie, on obtient une couche superficielle encore plus riche en chrome, ce qui est favorable à l'adhérence directe d'un revêtement organique.

Selon un mode de réalisation privilégié de l'invention, lesdits moyens pour diminuer l'angle d'émission sont formés par un écran mobile vertical disposé entre la source d'élément A et la source d'élément B.

Avantageusement, il est possible de régler, en cours de fonctionnement dudit procédé, simultanément les positions de l'écran mobile vertical et des bords d'entrée et de sortie. En procédant ainsi, on conserve la même épaisseur pour les deux sous-couches même si la vitesse de la ligne, le niveau des charges A et B dans les creusets des sources ou les débits d'évaporation sont modifiés.

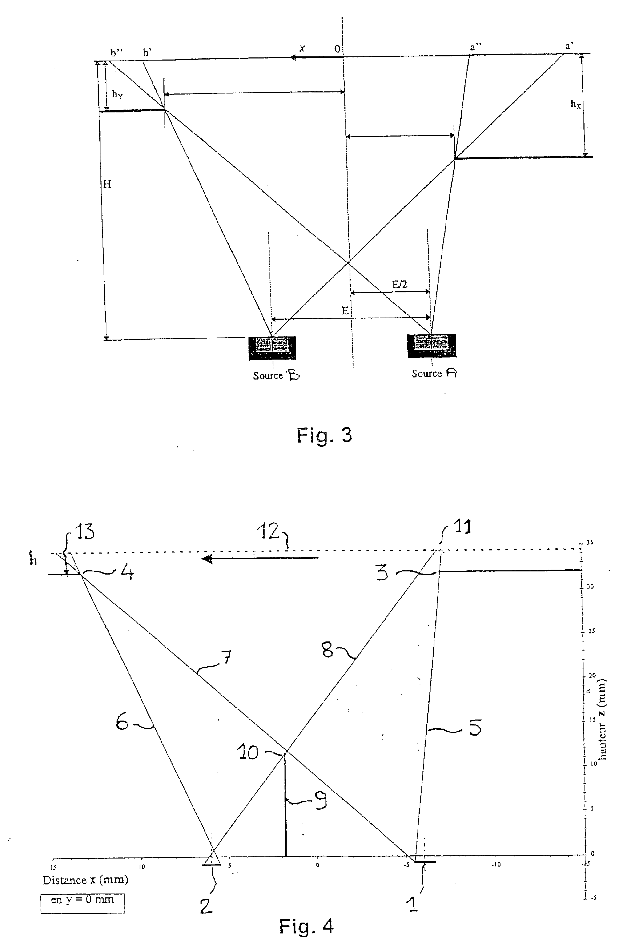

La figure 4 illustre de manière non limitative une telle installation, qui sera décrite de manière plus précise ultérieurement dans le cas particulier d'un revêtement comprenant une couche principale d'alliage zinc-chrome.

L'installation peut évidemment servir à revêtir des bandes continues de tôles.

Grâce à cette disposition, il est possible de réaliser des revêtements comprenant une couche d'alliage AB plus riche en élément A du côté du substrat,
- de type -A-AB, en diminuant l'angle d'émission de la source B en deçà de la limite représentée par le bord d'entrée A,
- de type -AB-B, en diminuant l'angle d'émission de la source A en deçà de la limite représentée par le bord de sortie B,
- de type -A-AB-B, en combinant les deux moyens ci-dessus.

Dans le cas où l'on utilise un écran mobile vertical, ces différentes variantes peuvent être obtenues en faisant varier la position de cet écran entre la source d'élément A et la source d'élément B ou en utilisant deux écrans.

En combinant avec les moyens décrits précédemment et illustrés aux figures 1 à 3, il est donc possible de réaliser des revêtements multi-couche, non réalisables par les dispositifs et procédés de dépôts sous vide décrits dans l'art antérieur, de type -A-AB-A ou de type -B-AB-B, où la couche d'alliage AB est plus riche en élément A du côté du substrat.

On va maintenant décrire plus précisément la tôle selon l'invention.

On sait que le chrome cristallise dans un système cubique centré a dont le paramètre de maille ao vaut environ 0,2884 nm (source : Handbook of Lattice Spacings and Structure of Metals ans Alloys, W.B. Pearson, Pergammon Press) ; on sait également qu'un alliage zinc-chrome riche en chrome cristallise dans le même système cubique centré, avec un paramètre de maille supérieur dont la valeur a₀' est généralement comprise entre 0,296 et 0,301 nm ; la quantité minimale de chrome nécessaire pour obtenir un alliage zinc-chrome présentant cette structure cubique centré dépend des conditions de préparation de l'alliage : en référence à la figure 5 qui représente le diagramme, établi par la demanderesse, de la synthèse des essais d'identification et de stabilité thermique des phases des alliages Zn-Cr en fonction de la teneur en chrome (%) obtenus par le procédé « PVD » (« Physical Vapor Deposition » en langue anglaise), on a constaté que la teneur pondérale minimum de chrome pour obtenir cette structure Γ variait ainsi de 20 à 34% environ selon ces conditions de préparation.

Grâce à la structure cubique centré de la couche sous-jacente d'alliage zinc-chrome riche en chrome selon l'invention, on a constaté qu'il était possible d'obtenir une jonction d'épitaxie partielle entre cet alliage et de l'acier.

Par le terme « jonction d'épitaxie partielle », on signifie qu'à l'interface entre le substrat et la couche sous-jacente de cet alliage sous forme cubique centré, il y a continuité entre certains des cristaux de ferrite de l'acier à cette interface et certains des cristaux cubique centré de l'alliage Zn-Cr à cette même interface.

Ainsi, en intercalant selon l'invention une couche sous-jacente d'alliage Zn-Cr de structure cubique centré entre un substrat d'acier et une couche principale d'alliage Zn-Cr beaucoup plus pauvre en chrome, ne cristallisant pas sous forme cubique centré Γ, et destinée à protéger efficacement l'acier contre la corrosion, on améliore très fortement l'adhérence de cette couche principale de protection sur le substrat, à condition d'établir une jonction d'épitaxie partielle entre l'acier et cette couche intercalée.

Un moyen pour vérifier que la jonction entre l'acier et cette couche intercalée présente un caractère d'épitaxie partielle consiste à réaliser un diagramme de diffraction électronique sur des lames minces obtenues par des coupes dans le plan de la couche intercalée, au voisinage de l'interface avec l'acier.

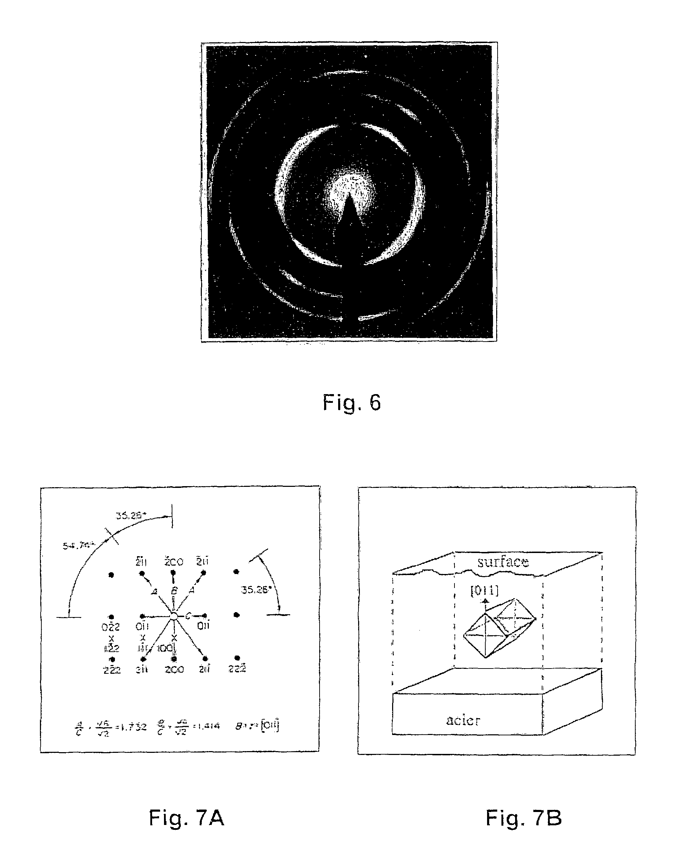

La figure 6 illustre le diagramme obtenu lorsque la jonction présente un caractère d'épitaxie : on observe que les anneaux de diffraction forment des traits interrompus et ne sont pas complets, ce qui indique que l'orientation des grains cubiques centrés de la couche intercalée dans le plan de coupe n'est pas aléatoire et qu'il existe une relation partielle d'épitaxie avec les grains situés en dessous du plan de coupe, c'est à dire avec les grains d'acier ; de plus, l'angle entre la position d'intensité maximum de l'anneau qui correspond aux plans cristallographiques {011} de la phase Γ-ZnCr et celui des plans {200} est 90°, ce qui indique une texture de croissance de type [011].

Les figures 7A et 7B représentent respectivement :
- la zone d'axe [011] (notation cristallographique) pour un réseau cristallin du type cubique centré du type de celui de l'alliage Zn-Cr riche en chrome de la couche intermédiaire selon l'invention,
- l'orientation préférentielle [011] pour la croissance des grains de cette couche intermédiaire, lors de son dépôt sur le substrat d'acier.

On a constaté que la couche sous-jacente selon l'invention pouvait apporter une amélioration significative de l'adhérence du revêtement à condition que son épaisseur dépasse 0,01 µm ; de très bons résultats ont été obtenus avec une épaisseur de 0,02 µm environ ; comme la phase Γ présente un caractère fragile, il convient d'éviter que cette couche ne soit trop épaisse, pour éviter les problèmes au moment de la mise en forme de la tôle revêtue ; ainsi, de préférence l'épaisseur de cette couche est inférieure à 1 µm.

On utilise notamment l'invention pour améliorer l'adhérence de couches Zn-Cr à gradient, dont la teneur en chrome est plus importante en profondeur qu'en surface, telles que décrites dans le document JP 03-191053 déjà cité.

Une variante de l'invention consiste à soumettre la tôle obtenue à un traitement thermique de manière à transformer, au moins en partie, la phase δ de la couche principale du revêtement en phase ζ , tel que décrit par exemple dans le document JP 08-013192 qui indique qu'un tel traitement permet d'améliorer la résistance à la rouille rouge de la tôle.

Pour préparer une tôle d'acier revêtue selon l'invention, on utilise de préférence un procédé de dépôt sous vide ; en effet, ce type de procédé permet de contrôler plus facilement les proportions de chrome et de zinc, qui sont variables dans l'épaisseur du revêtement : teneur en chrome plus élevée au voisinage de l'acier pour former la couche intermédiaire d'adhérence selon l'invention, teneur en chrome plus faible au voisinage de la surface.

Une autre variante de l'invention pour transformer, au moins en partie, la phase δ de la couche principale du revêtement en phase ζ lorsque le dépôt est réalisé sous vide, consiste à réaliser le dépôt sur un substrat porté à une température supérieure à 170°C ; par observation en coupe au microscope électronique à balayage, on constate alors une modification de la microstructure de la couche principale du revêtement :
- à 150°C, on observe une morphologie analogue à celle que l'on obtient sans préchauffage : la couche principale présente une morphologie colonnaire dont les cristaux sont orientés perpendiculairement à la surface du substrat ou au plan de la couche, et s'étendent sur toute l'épaisseur de cette couche (épaisseur de l'ordre de 5 µm) ; les joints de grains traversent donc la couche de part en part.
- à 200°C, la couche principale présente une morphologie «duplex» : de la surface jusqu'à environ la mi-épaisseur de la couche, la morphologie reste colonnaire, alors que, plus en profondeur, la morphologie est quasiment équiaxe ; les analyses par diffraction des rayons X montrent que l'alliage ZnCr déposé est partiellement transformé en phase ζ. Dans les conditions suivantes d'analyse par diffraction des rayons X : tube rayons X anti-cathode de cobalt (30kV-30mA avec Ka=0,179026nm), monochromateur arrière et détecteur à scintillations, dispositif d'incidence rasante (angle d'incidence a=3°), la hauteur de la raie (131) de la phase ζ-Zncr est égale ou légèrement inférieure à la hauteur de la raie (0002) de la phase δ-ZnCr.
- à 240°C, la couche obtenue est entièrement transformée (morphologie équiaxe) mais présente une faible compacité du fait de la ré-évaporation partielle du zinc dans les conditions de dépôt sous vide.

Ainsi, selon cette variante qui vise l'obtention d'un revêtement dont la couche principale est transformée, au moins partiellement, en phase ζ , on chauffe de préférence la tôle à revêtir entre 170°C et 230°C ; en chauffant le substrat dans le domaine 170 à 200°C environ, on parvient à des revêtements dont la couche principale est bi-phasée, pour lesquels la hauteur de la raie (131) de la phase ζ-Zncr est comprise entre 10 et 100% approximativement de la hauteur de la raie (0002) de la phase δ-ZnCr.

Sans traitement thermique ultérieur, on parvient ainsi à réaliser un revêtement dont la couche principale présente une phase prédominante ζ.

En effectuant postérieurement au dépôt un traitement thermique adapté, on parvient, le cas échéant, à transformer totalement la structure de la couche principale en phase ζ de morphologie équiaxe présentant, sur toute l'épaisseur de cette couche, des grains de très petite taille, par exemple une taille comprise entre 10 et 200 nm.

Un avantage de cette variante de l'invention est qu'un traitement ultérieur du type de celui qu'on effectue pour la cuisson d'une couche de peinture suffit à compléter la transformation d'une quantité suffisante de phase δ en phase ζ pour obtenir la meilleure résistance à la corrosion ; il n'est donc plus nécessaire d'effectuer un traitement thermique ultérieur spécifique pour obtenir l'amélioration de la résistance à la corrosion.

Dès lors que la phase ζ est prépondérante dans le revêtement, on observe une amélioration sensible de la protection contre la corrosion apportée par ce revêtement par rapport au revêtement de même épaisseur et de même composition, mais dont la phase prépondérante est la phase δ ; cette amélioration proviendrait, au moins pour partie, de la structure microcristalline obtenue par chauffage du substrat pendant et/ou après revêtement ; en effet, le fait qu'aucun joint de grain ne traverse plus directement la couche de part en part comme dans le cas de la morphologie colonnaire pourrait expliquer l'amélioration sensible de la résistance à la corrosion.

La couche sous-jacente d'adhérence selon l'invention est particulièrement avantageuse, parce que, même en cas de dépôt sur substrat chauffé et/ou en cas de traitements thermiques ultérieurs, la phase Γ de cette couche sous-jacente est très stable en température et continue d'apporter l'effet spécifique de l'invention d'amélioration de l'adhérence du revêtement, même après transformation de la phase δ en phase ζ.

L'invention sera mieux comprise à la lecture de la description qui va suivre, donnée à titre d'exemple non limitatif, et en référence aux figures annexées sur lesquelles :
- les figures 1 à 3 décrivent des schémas de chambre d'évaporation et/ou de sublimation pour le dépôt sous vide de revêtement comprenant une couche principale d'alliage AB plus riche en élément A du côté du substrat qu'en surface, constitué de l'empilement-AB-A, -B-AB, et -B-AB-A.
- la figure 4 décrit un schéma d'une chambre aménagée selon l'invention par un écran 9, de manière à obtenir un revêtement constitué de l'empilement - A-AB-A.
- la figure 5 présente le diagramme, établi par la demanderesse, de la synthèse des essais d'identification et de stabilité thermique des phases des alliages Zn-Cr en fonction de la teneur en chrome (%), dans le cas particulier de dépôts réalisés sous vide par « PVD » (Physical Vapor Deposition en langue anglaise).
- la figure 6 illustre le diagramme de diffraction électronique obtenu lorsque la jonction entre le substrat et la couche sous-jacente selon l'invention présente un caractère d'épitaxie.
- les figures 7A et 7B représentent respectivement la zone d'axe [011] de la couche sous-jacente selon l'invention, et l'orientation préférentielle [011] pour la croissance des grains de cette couche.

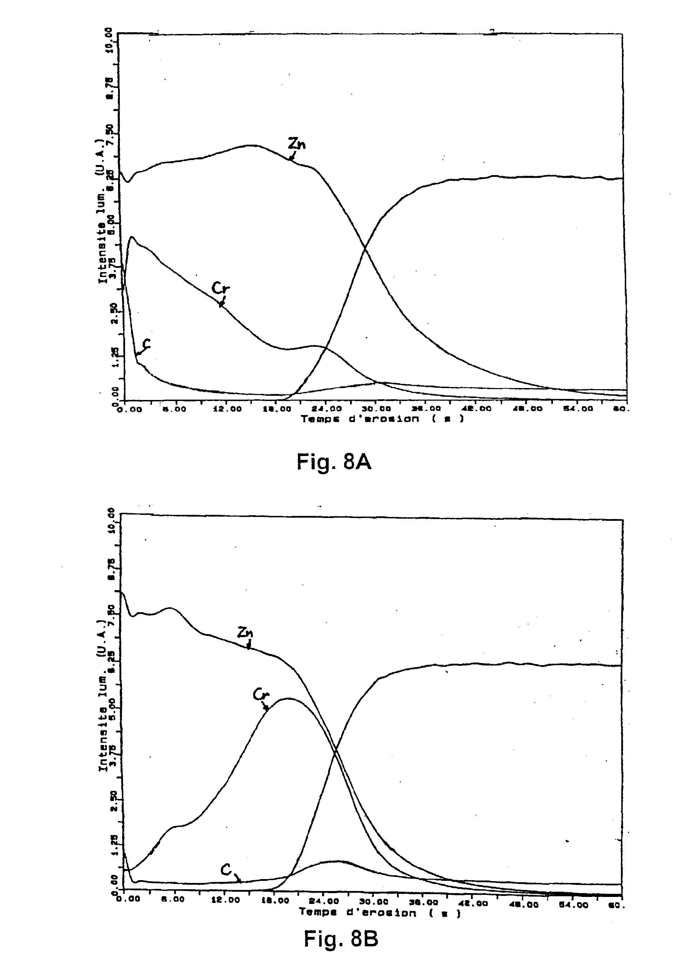

- les figures 8A et 8B illustrent l'évolution de la concentration en Zn, Cr et Fe en fonction de la profondeur par rapport à la surface par spectroscopie de décharge luminescente (intensité de luminescence - UA : unité arbitraire- en fonction du temps d'érosion - secondes) pour des échantillons dotés d'un revêtement selon l'invention dont la couche principale est une couche à gradient, plus riche en chrome vers la surface pour la figure 5A, plus riche en chrome vers le substrat pour la figure 8B.

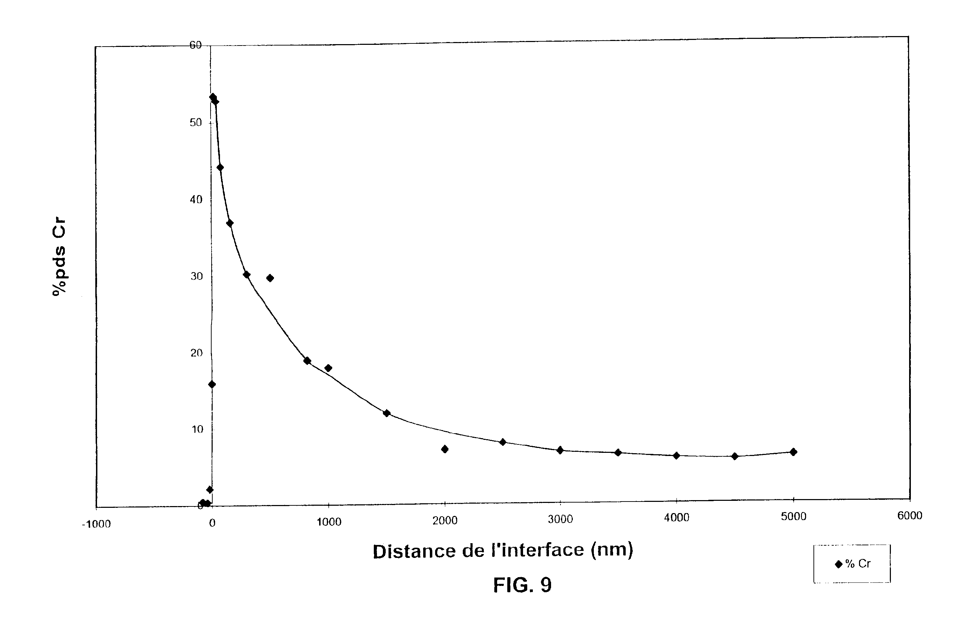

- la figure 9 illustre l'évolution de la concentration en Cr (% en poids) en fonction de la distance à l'interface avec le substrat (µm) pour un échantillon analogue à celui de la figure 8B, après recuit à 225°C pendant 60 min., évaluée par « EDX » (« Energy Dispersive X-ray analysis » en langue anglaise ) en MET (Microscopie Electronique en Transmission).

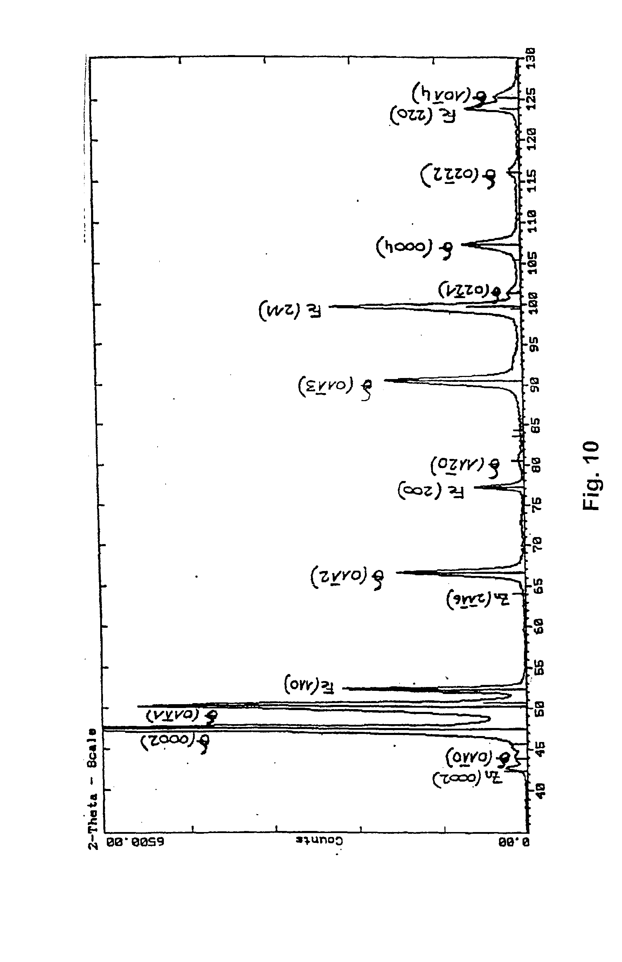

- la figure 10 est un diagramme de diffraction par rayons X effectué sur la surface d'une tôle dotée d'un revêtement selon l'invention dont la couche principale d'alliage Zn-Cr présente une structure δ.

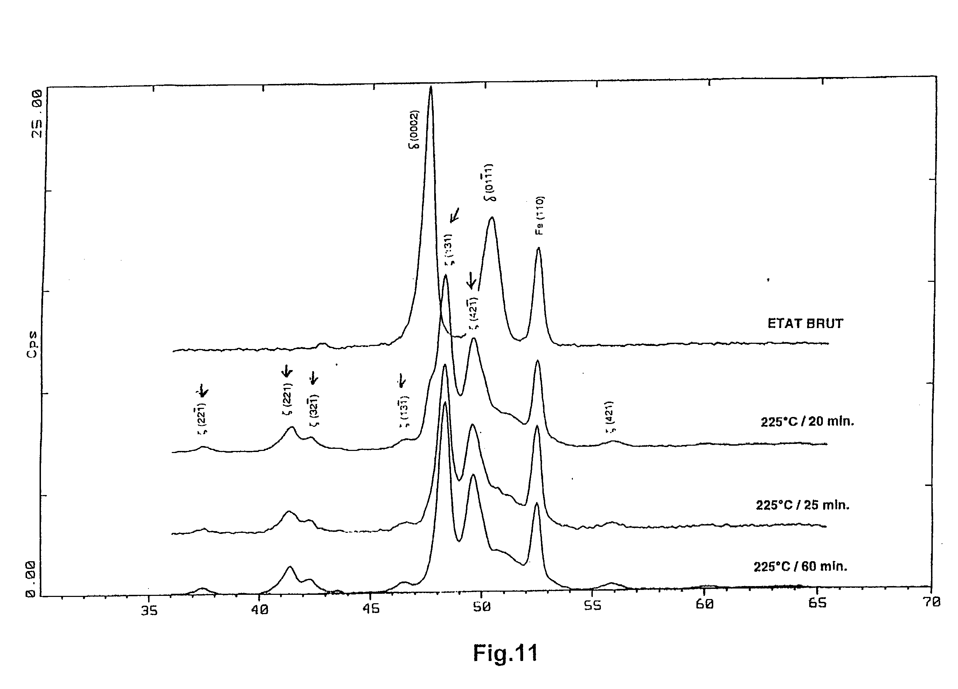

- la figure 11 illustre, toujours par diffraction des rayons X, l'évolution de l'intensité de diffraction de raies caractéristiques des structures du revêtement pour différentes durées (20, 25 et 60 minutes) de recuit à 225°C après dépôt du revêtement.

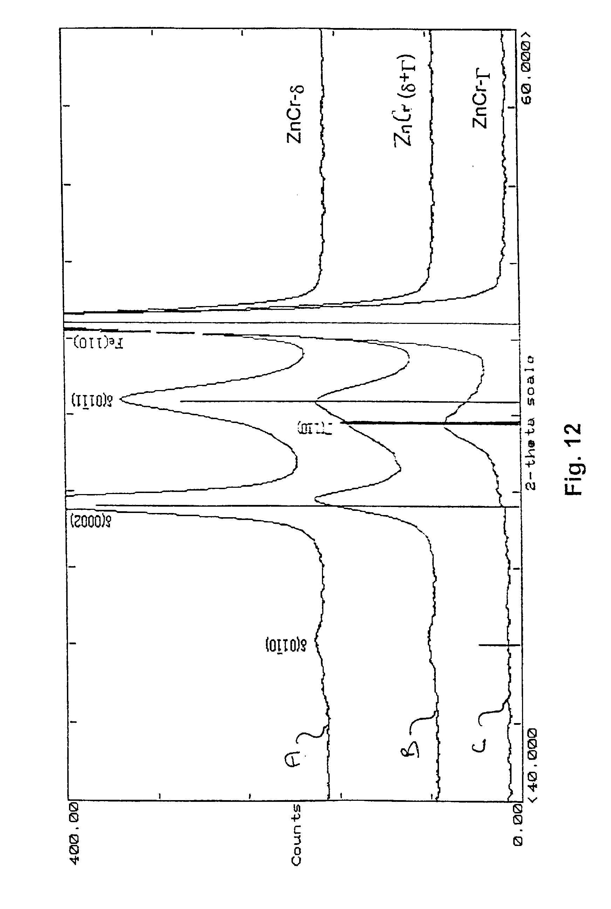

- la figure 12 illustre, toujours par diffraction des rayons X, l'évolution de l'intensité de diffraction de raies caractéristiques des structures du revêtement en fonction de la profondeur : courbe Zncr-δ en surface, courbe ZnCr(δ + Γ) au niveau de la moitié de l'épaisseur du revêtement, courbe ZnCr-Γ à proximité de l'interface avec le substrat.

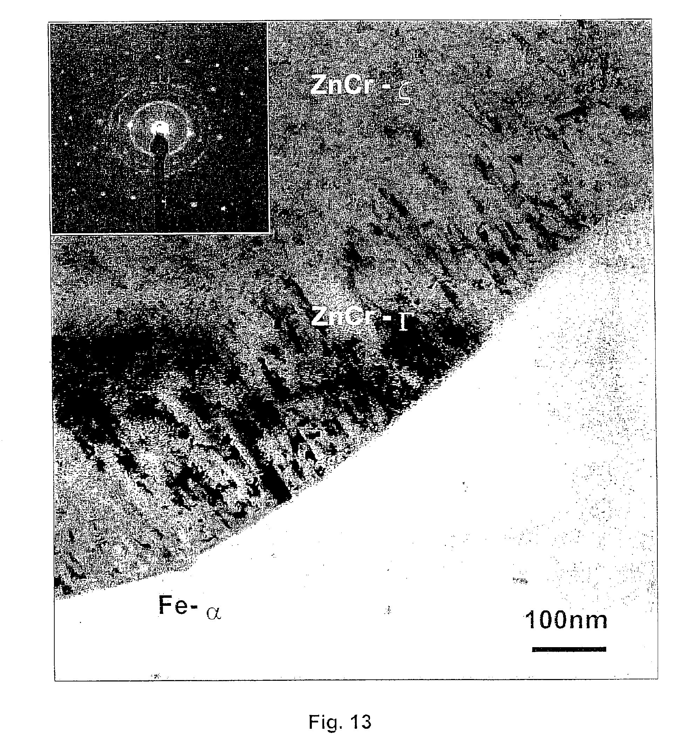

- la figure 13 est une microphotographie à fort grossissement dans la zone d'interface entre le substrat et le revêtement, mettant en évidence la couche sous-jacente selon l'invention marquée ZnCr-Γ et sa structure Γ identifiée par le diagramme de diffraction électronique du coin supérieur gauche de la photo.

Pour illustrer un mode de préparation d'une tôle selon l'invention, on va utiliser un procédé classique de dépôt d'alliage zinc-chrome, en l'occurrence un procédé de dépôt sous vide ; d'autres procédés pourraient être utilisés, comme l'électrodéposition telle que décrite dans le document EP 0 607 452 déjà cité.

Pour obtenir, selon l'invention, la jonction partielle par épitaxie entre l'acier et le dépôt, il importe de partir d'une surface d'acier propre et réactive, comme celle qu'on obtient directement en sortie d'une ligne de recuit continue effectué sous atmosphère réductrice.

Si la surface n'est pas suffisamment propre et réactive, il importe alors de procéder à une opération préalable de nettoyage et d'avivage dans des conditions permettant d'obtenir, selon l'invention, la jonction partielle par épitaxie entre l'acier et le dépôt.

A cet effet, on utilise par exemple un traitement sous plasma ou un traitement par bombardement ionique ; dans le cas d'un bombardement ionique par faisceau d'ions d'argon, la densité de bombardement nécessaire dépasse de préférence 10¹⁶ ions/cm² de surface à nettoyer.

Les conditions de nettoyage et d'avivage de la surface sont adaptées d'une manière connue en elle-même pour obtenir une surface aussi propre et réactive qu'en sortie de recuit, par exemple selon le procédé décrit dans FR 2 757 880 (SOLLAC) en fonction de l'intensité de luminescence d'au moins un élément traceur de la surface à revêtir.

Pour la suite de la préparation de la tôle selon l'invention, on va maintenant décrire, à titre d'illustration de l'invention, l'application d'un revêtement comportant une couche principale d'alliage zinc-chrome à gradient, plus riche en chrome au voisinage du substrat qu'au voisinage de la surface, adaptée pour apporter à la fois une protection efficace contre la corrosion et une bonne phosphatabilité, et, à cette fin, l'utilisation d'une installation de dépôt sous vide de type « PVD » (Physical Vapor Deposition » en langue anglaise) présentant des aménagements particuliers.

D'une manière classique, l'installation de dépôt sous vide comporte des moyens de défilement de tôle ou d'une bande de tôle, une chambre d'évaporation et/ou de sublimation ouverte sur une fenêtre d'évaporation et/ou de sublimation débouchant sur une zone du chemin de défilement de la tôle.

Pour préparer un tel revêtement, l'installation de dépôt sous vide par « PVD » est de préférence aménagée comme suit en référence à la figure 4 :
- comme sources de zinc et de chrome, on utilise deux creusets séparés disposés dans la chambre d'évaporation et/ou de sublimation, l'un 1 de sublimation du chrome pur et l'autre 2 d'évaporation du zinc pur ; d'autres dispositions connues permettent de déposer des alliages zinc-chrome, comme un seul creuset contenant un alliage zinc-chrome, mais ne conviennent pas ici ; en effet, l'utilisation d'un seul creuset ne permettrait pas d'obtenir une couche principale à gradient ;
- les deux creusets 1, 2 sont disposés successivement sur une direction parallèle à celle du défilement de la tôle, ce qui permet d'obtenir une couche à gradient ;
- dans le sens de défilement de la tôle (flèche 12 dans le haut de la figure 4), sur cette direction parallèle, on trouve d'abord le creuset de chrome 1, puis le creuset de zinc 2 ; ainsi, la couche à gradient obtenue est plus riche en chrome du côté du substrat que du côté de la surface, conformément à l'objectif poursuivi dans ce mode particulier de réalisation de l'invention.

La fenêtre d'évaporation ou de sublimation devant laquelle défile la tôle à revêtir est délimitée, dans la direction perpendiculaire au défilement, par un bord d'entrée 3 du côté du creuset 1 et par un bord de sortie 4 du côté du creuset 2.

Ainsi, sur la figure 4, le bord d'entrée 3 définit la limite droite 5 de l'angle solide d'émission à partir du creuset 1 de chrome et le bord de sortie 4 définit la limite gauche 6 de l'angle solide d'émission à partir du creuset 2 de zinc.

En l'absence d'autres aménagements, le bord d'entrée 3 définirait aussi la limite droite de l'angle solide d'émission à partir du creuset 2 de zinc ; le bord de sortie 4 définit la limite gauche 7 de l'angle solide d'émission à partir du creuset 1 de chrome.

Comme ces bords 3 et 4 sont, en pratique, toujours situés à distance non nulle h du chemin de défilement de la tôle :
- du côté du bord de sortie 4 qui fixe les limites gauches 6, 7 des angles d'émission respectivement de zinc et de chrome, l'angle solide d'émission de chrome est plus ouvert que celui de zinc, et on forme sur le chemin de défilement une zone 13 sur laquelle se condensent majoritairement des éléments chrome après le dépôt de la couche principale d'alliage.
- du côté du bord d'entrée 3 qui fixe la limite droite 5 de l'angle d'émission du chrome et fixerait la limite droite de l'angle d'émission du zinc en l'absence d'autres aménagements, l'angle solide d'émission du zinc serait plus ouvert que celui du chrome, et on formerait sur le chemin de défilement une zone sur laquelle se condenseraient majoritairement des éléments zinc avant le dépôt de la couche principale d'alliage.

Ainsi, en pratiquant le dépôt en l'absence d'autres aménagements, on obtiendrait une tôle dotée d'un revêtement comprenant :
- une couche sous-jacente de zinc ou d'alliage zinc-chrome riche en zinc,
- une couche principale d'alliage zinc-chrome à gradient,
- une couche superficielle de chrome ou d'alliage zinc-chrome riche en chrome.

Un tel revêtement pose des problèmes d'adhérence, que la présence de la couche sous-jacente de zinc ou d'alliage zinc-chrome riche en zinc aggrave, que l'invention a pour but de résoudre.

Ainsi, pour obtenir une couche sous-jacente d'adhérence selon l'invention, dans l'installation de dépôt sous vide par « PVD », on dispose en outre un écran vertical mobile 9 en translation dans un plan perpendiculaire à la direction de défilement, dont la position peut varier entre le creuset 1 (source d'élément A) et le creuset 2 (source d'élément B), plus proche du creuset 2 de zinc que du creuset 1 de chrome, de manière à diminuer l'angle d'émission à partir du creuset 2 de zinc en deçà de la limite droite qui aurait été définie par le bord d'entrée 3, c'est à dire de manière à ce que le bord supérieur 10 de cet écran vertical mobile 9 définisse maintenant la limite droite de l'angle solide d'émission à partir du creuset 2 de zinc.

La limite gauche 7 de l'angle solide d'émission à partir du creuset 1 de chrome est, quant à elle, toujours définie par le bord de sortie 4 de la fenêtre d'évaporation ou de sublimation et n'est pas affectée par l'écran vertical mobile 9.

Grâce à cet écran 9 ainsi positionné selon l'invention, il existe dans la fenêtre une zone au travers de laquelle passent essentiellement des éléments « chrome » de manière à former, de l'autre côté de la fenêtre sur la tôle en défilement, une zone 11 sur laquelle se condensent majoritairement des éléments chrome.

Ainsi, après la préparation de la surface à revêtir, en faisant défiler la tôle dans cette installation dotée de ces aménagements comportant notamment l'écran 9 :
- dans la zone 11, on forme d'abord une couche sous-jacente riche en chrome, dont l'épaisseur est proportionnelle, entre autres paramètres, à la largeur de la zone 11, cette largeur étant réglable en fonction de la position de l'écran 9,
- dans la zone 12 où se condensent à la fois du zinc et du chrome, on forme ensuite une couche principale d'alliage zinc-chrome, à gradient, dont la concentration en chrome est plus élevée du côté du substrat que de la surface,
- dans la zone 13, on forme ensuite une couche superficielle, riche en chrome comme la couche sous-jacente, dont l'épaisseur est proportionnelle à la distance h entre le bord de sortie 4 et le chemin de défilement de la tôle.

L'épaisseur du revêtement et, donc, de chaque couche, est évidemment proportionnelle à la vitesse de défilement de la tôle et à la vitesse d'évaporation ou de sublimation.

Pour diminuer l'angle d'émission de la source d'élément Zn en deçà de la limite représentée par le bord d'entrée 3, on pourrait, sans se départir de l'invention concernant les aménagements de l'installation, utiliser d'autres moyens que l'écran 9 précédemment décrit : on pourrait par exemple utiliser le creuset 1 comme écran des éléments émis par le creuset 2, en le disposant à une hauteur adaptée dans la chambre d'évaporation et de sublimation.

Pour obtenir un revêtement dont la couche principale présente une composition qui varie de 15% en poids de chrome au voisinage du substrat à 5% au voisinage de la surface et dont l'épaisseur est de 4,5 µm, on calcule d'une manière connue en elle-même :
- les conditions portant notamment sur les vitesses d'évaporation, de sublimation et de défilement,
- les conditions de réglage des faisceaux d'électrons de bombardement de la surface des creusets, en fonction, également, des cônes d'évaporation requis.

On procède par exemple dans les conditions suivantes :
- vitesse d'évaporation du zinc : 70,0 mg/s.
- vitesse de sublimation du chrome : 3,5 mg/s.
- vitesse de défilement de la tôle : 5 cm/min.

La pression dans l'installation de revêtement est de l'ordre de 10⁻³ Pa ; à cette pression, le libre parcours moyen des atomes évaporés ou sublimés est supérieur à 50 cm, ce qui permet de considérer que la majeure partie des atomes sortant des creusets en direction de la fenêtre d'évaporation ou de sublimation ne subissent pas de collisions et se propagent en lignes droites.

En pratique, à partir des dimensions de la chambre et de la fenêtre d'évaporation et de sublimation, de la position et des caractéristiques des creusets 1, 2, de la variation des niveaux des charges de zinc et chrome de ces creusets au cours de l'application du revêtement sur la tôle, on calcule la position de l'écran 9, par rapport aux deux creusets et en hauteur, et la forme de son bord supérieur 10 pour obtenir l'épaisseur souhaitée de couche sous-jacente riche en chrome et une épaisseur constante de cette couche sous-jacente sur toute la largeur de la tôle.

Ainsi, après mise en oeuvre de ce procédé comportant une étape de préparation de la surface de la tôle et une étape de dépôt sous vide « PVD » par défilement de la tôle au dessus de la fenêtre d'évaporation et/ou de sublimation, on obtient une tôle d'acier dotée d'un revêtement d'une épaisseur totale de l'ordre de 5 µm comprenant :
- une couche sous-jacente d'alliage zinc-chrome beaucoup plus riche en chrome que la couche principale, dont la teneur pondérale moyenne en chrome est supérieure à 34%, d'épaisseur de l'ordre de 0,2 µm,
- une couche principale d'alliage zinc-chrome à gradient, dont la teneur pondérale moyenne en chrome est de l'ordre de 10%, d'épaisseur 4,5 µm.

En pratique, compte tenu de la faible distance h (cf. figure 4) séparant le bord de sortie 4 de la zone 13, on n'a pas observé de couche superficielle d'alliage zinc-chrome beaucoup plus riche en chrome que la couche principale.

Sans se départir de l'invention, le revêtement peut comprendre une telle couche superficielle, notamment si l'on éloigne le bord de sortie 4 de la zone 13.

On va maintenant décrire plus en détail les caractéristiques physico-chimiques et les propriétés de la tôle obtenue.

### 1 - Analyse de la teneur pondérale en éléments dans l'épaisseur de la tôle, notamment du revêtement :

- teneurs en zinc, chrome, fer et carbone par spectroscopie de décharge luminescente, en fonction du temps d'érosion : figure 8B.
- teneur en chrome en fonction de la distance (µm) à l'interface acier-revêtement, par analyse « EDX » (abréviation en langue anglaise de l'expression « Energy Dispersive X-ray analysis ») au microscope électronique à transmission sur une lame mince d'une coupe transverse de tôle selon l'invention, obtenue par une méthode « FIB » (« Focussed Ion Beam » en langue anglaise) n'endommageant pas la coupe : figure 9.

La méthode « FIB » est décrite dans l'article écrit par K.Kuroda, M. Takahashi, T.Kato, H. Saka, S. Tsuji, intitulé « Application of focussed ion beam milling to cross-sectional TEM (ou MET en langue française) spécimen preparation of industrial materials including heterointerfaces », publié dans la revue Thin Solid Films, 319, pp.92-96, (1998).

Les spectres de décharge luminescente montrent bien l'augmentation de la concentration et la diminution de celle de chrome dans la couche principale du revêtement, ce qui manifeste que cette couche principale d'alliage Zn-Cr est bien « à gradient » ; l'augmentation du signal lié au zinc à la surface ne reflète pas une concentration plus importante de zinc mais n'est qu'un artefact lié à la méthode d'analyse, le zinc ayant un coefficient de pulvérisation quatre fois supérieur à celui du chrome.

L'analyse « EDX » montre un profil général de diminution de la concentration en chrome dans la couche principale du revêtement jusqu'à 5% environ en poids au voisinage de la surface ; cette analyse révèle la présence de la couche sous-jacente d'alliage zinc-chrome selon l'invention, beaucoup plus riche en chrome (supérieure à 34% en poids) que la couche principale au voisinage de ce substrat, dont la concentration en chrome ne dépasse pas 30% en se référant aux analyses précédentes.

### 2 - Analyse des phases cristallines dans le revêtement :

### 2.1 : par DRX (Diffraction Rayons X), concernant la couche principale du revêtement :

Comme le montre le diagramme de diffraction par rayons X effectué sur la surface de la tôle - figure 10, l'alliage Zn-Cr de la couche principale du revêtement est presque entièrement composé de la phase hexagonale δ.

Comme le montrent les diagrammes de la figure 11 effectués sur une tôle brute de référence issue directement de l'opération de dépôt et sur des tôles revêtues ayant en outre subi un traitement de recuit à 225°C pendant une durée variable (20, 25 et 60 minutes), on voit que :
- dès le recuit à 20 minutes, la phase ζ apparaît en proportion très significative (raies repérées par une flèche sur la figure) ; l'épaulement gauche de la raie (131) laisse penser qu'on trouve encore de la phase δ.
- pour des durées supérieures, la phase δ semble avoir disparu ; la largeur des raies principales de la phase ζ ne diminue pas sensiblement.

### 2.2 : par RX, concernant la couche sous-jacente selon l'invention :

Afin d'analyser l'évolution de la structure cristallographique du revêtement en fonction de la profondeur, on a préparé un échantillon dit « interrompu » en procédant par dépôt sous vide comme précédemment décrit, à la différence près qu'on arrête le défilement de la tôle tout en arrêtant le dépôt, de manière à ce que :
- la zone C d'échantillon arrêtée au niveau de la zone 11 (figure 4) ne comprend que la couche sous-jacente d'adhérence,
- la zone A d'échantillon arrêtée au niveau de la zone 13 (figure 4) comprend la totalité du revêtement tel que précédemment décrit.
et les zones intermédiaires comprennent une partie seulement de la couche principale ; on considère une zone B d'échantillon correspondant à la moitié environ de l'épaisseur de la couche.

La figure 12 illustre les diagrammes de diffraction par rayons X, obtenus sous incidence rasante, des zones A (courbe A), B (courbe B) et C (courbe C) ; on retrouve la phase δ majoritaire sur la courbe A et sur la courbe B, ce qui confirme la structure de la couche principale du revêtement ; on détecte la phase Γ sur la courbe C (au niveau 2 θ ≈ 50.000) , ce qui confirme la structure de la couche sous-jacente d'adhérence selon l'invention ; on détecte même la trace de la phase Γ sur la courbe B.

### 2.3 : par diffraction électronique, concernant la couche sous-jacente selon l'invention :

Sur un échantillon de tôle doté du revêtement selon l'invention tel que précédemment décrit, on effectue un recuit à 225°C pendant 1h, de manière à transformer la structure de la couche principale de ce revêtement en structure ζ

On réalise une lame mince de cet échantillon recuit en pratiquant une coupe dans un plan perpendiculaire au revêtement: la photographie au microscope électronique à transmission de cette coupe est reportée à la figure 13 : on distingue nettement sur le substrat Fe-α, d'abord la couche sous-jacente d'adhérence ZnCr-Γ , puis le début de la couche principale ZnCr-ζ.

Le diagramme de diffraction électronique de la couche d'adhérence ZnCr- Γ est représenté sur le coin supérieur gauche de cette photographie ; ce cliché de diffraction montre que cette couche d'adhérence a une structure cubique centrée (aₒ=0,300nm) qui correspond à la phase ZnCr-Γ (voir les anneaux sur le cliché ; les taches proviennent du substrat α-Fe [114]).

On constate également que :
- la couche sous-jacente d'adhérence s'est maintenue après recuit,
- la morphologie de la phase ζ est très fine : taille des cristaux largement inférieure à 100 nm.

### 2.4 : concernant l'interface entre le substrat et la couche sous-jacente :

Sur une tôle revêtue uniquement par un alliage ZnCr de structure Γ, on réalise un diagramme de diffraction électronique sur des lames minces obtenues par des coupes dans le plan de la tôle.

La figure 6 illustre le diagramme obtenu : on observe que les anneaux de diffraction forment des traits interrompus et ne sont pas complets, ce qui indique que l'orientation des grains de la phase Γ de la couche sous-jacente n'est pas aléatoire et qu'il existe une relation partielle d'épitaxie avec les grains situés en dessous du plan de coupe, c'est à dire avec les grains d'acier du substrat.

### 3.- Tests d'adhérence du revêtement sur le substrat de tôle d'acier :

On prépare trois échantillons de tôle :
- un échantillon n°1 selon l'invention, préparé dans les mêmes conditions que celles précédemment décrites,
- un échantillon n°2 préparé dans les mêmes conditions que celles précédemment décrites, mais sans utiliser d'écran 9 dans l'installation de dépôt, de sorte que le revêtement obtenu ne comporte pas de couche sous-jacente selon l'invention, plus riche en chrome que la couche principale au voisinage du substrat.
- un échantillon n°3 préparé dans les mêmes conditions que celles précédemment décrites sur une surface propre mais non réactive : un stockage de quelques jours en atmosphère propre suffit à rendre la surface non réactive.

Pour ces trois échantillons, le revêtement comporte la même couche principale d'alliage zinc-chrome précédemment décrite : épaisseur 4,5 µm environ, à gradient, phase δ.

Sur ces trois échantillons, on effectue le test d'adhérence du revêtement suivant: on plie l'échantillon à 180°, on applique un ruban adhésif de type Scotch^{TM} sur la zone de pliage, on arrache le ruban appliqué, puis on observe sur la surface de l'échantillon si le revêtement est intact ou partiellement arraché ou totalement arraché.

Le résultat des observations est le suivant :
- échantillon n°1 : revêtement intact,
- échantillon n°2 : revêtement partiellement arraché,
- échantillon n°3 : revêtement totalement arraché.

On en déduit donc que la sous-couche selon l'invention présentant une relation partielle d'épitaxie avec le substrat d'acier améliore sensiblement l'adhérence de revêtement à base d'alliage zinc-chrome.

Selon une variante de l'invention, on peut disposer dans l'installation de revêtement un deuxième écran vertical mobile , positionné cette fois plus prés de la source de chrome que de la source de zinc, de manière à diminuer l'angle d'émission de la source 1 de chrome en deçà de la limite représentée par le bord de sortie 4.

Ainsi, on obtient alors une tôle d'acier selon l'invention dotée d'un revêtement comprenant :
- comme précédemment, une couche sous-jacente d'alliage zinc-chrome beaucoup plus riche en chrome que la couche principale,
- comme précédemment, une couche principale d'alliage zinc-chrome à gradient,
- une couche superficielle d'alliage zinc-chrome, cette fois beaucoup plus riche en zinc que la couche principale.

En inversant le sens de défilement de la tôle dans l'installation de revêtement sous vide précédemment décrite, même en l'absence d'écran 9, on peut obtenir une tôle dotée d'un revêtement comportant :
- une couche principale d'alliage zinc-chrome à gradient, cette fois plus pauvre en chrome au voisinage du substrat qu'au voisinage de la surface,
- et, selon l'invention, une couche sous-jacente d'alliage zinc-chrome beaucoup plus riche en chrome que la couche principale.

En référence à la figure 8A, l'analyse de la teneur pondérale en éléments, zinc, chrome, fer et carbone, dans l'épaisseur de la tôle par spectroscopie de décharge luminescente, en fonction du temps d'érosion montre bien :
- un profil inverse de concentration en chrome dans la couche principale du revêtement, manifestant l'inversion du gradient : plus riche en chrome au voisinage de la surface qu'en profondeur,
- une zone enrichie en chrome à l'interface entre le substrat d'acier et la couche principale du revêtement, manifestant la présence d'une couche sous-jacente selon l'invention.

## Revendications

1. Tôle d'acier dotée d'un revêtement comprenant une couche principale d'alliage zinc-chrome, dont la phase prépondérante présente une structure δ et/ou ζ, caractérisée en ce que ledit revêtement comprend également une couche sous-jacente d'adhérence en alliage zinc-chrome, intercalée entre l'acier de la tôle et ladite couche principale, qui présente :
- une structure cristalline cubique centré de type Γ,
- une teneur pondérale en chrome suffisamment élevée pour obtenir ladite structure Γ,
- une jonction au moins partielle d'épitaxie avec ledit acier, manifestée par la présence d'anneaux incomplets sur un diagramme de diffraction électronique de ladite sous-couche réalisé sur des coupes pratiquées au voisinage de l'interface avec l'acier, parallèlement à cette interface.

2. Tôle selon la revendication 1 caractérisée en ce que la teneur pondérale en chrome dans ladite couche sous-jacente est comprise entre 30 et 70%.

3. Tôle selon l'une quelconque des revendications 1 à 2 caractérisée en ce que l'épaisseur de ladite couche sous-jacente est comprise entre 0,01 µm et 1 µm.

4. Tôle selon l'une quelconque des revendications 1 à 3 caractérisée en ce que l'épaisseur de ladite couche principale est supérieure à 1 µm.

5. Tôle selon l'une quelconque des revendications précédentes caractérisée en ce que ladite couche principale est une couche à gradient de concentration de chrome.

6. Tôle selon la revendication 5 caractérisée en ce que la variation de concentration de chrome dans l'épaisseur de ladite couche principale est supérieure ou égale à 10% en poids.

7. Tôle selon l'une quelconque des revendications 5 à 6 caractérisée en ce que la concentration de chrome dans ladite couche principale est plus élevée au voisinage de la surface qu'au voisinage de l'acier.

8. Tôle selon l'une quelconque des revendications 5 à 6 caractérisée en ce que la concentration de chrome dans ladite couche principale est plus élevée au voisinage de l'acier qu'au voisinage de la surface.

9. Tôle selon l'une quelconque des revendications précédentes caractérisée en ce que la phase prépondérante de la couche principale présente une structure ζ.

10. Tôle selon l'une quelconque des revendications précédentes caractérisée en ce que,
si on soumet son revêtement à un rayonnement X sous incidence rasante de l'ordre de 3°, ledit rayonnement provenant d'un tube à rayons X à anti-cathode de cobalt alimenté sous 30kV et débitant 30mA, émettant une raie de longeur d'onde Ka = 0,179026 nm,
et si l'on analyse la diffraction de ce rayonnement à l'aide d'un monochromateur arrière et d'un détecteur à scintillations,
la hauteur de la raie de diffraction (131) de la phase ζ-Zncr est comprise entre 10% et 100% environ de la hauteur de la raie (0002) de la phase δ-ZnCr.

11. Procédé de fabrication d'une tôle selon l'une quelconque des revendications précédentes à partir d'une tôle à revêtir, caractérisé en ce qu'il comprend une étape dans laquelle ledit revêtement est appliqué par dépôt sous vide sur la surface de ladite tôle à revêtir.

12. Procédé selon la revendication 11 caractérisé en ce que ledit revêtement est appliqué par évaporation et/ou sublimation sous vide de zinc et de chrome.

13. Procédé selon la revendication 12 caractérisé en ce que ladite tôle à revêtir est portée pendant le dépôt à une température comprise entre 170°C et 230°C environ.

14. Procédé selon l'une quelconque des revendications 11 à 13 caractérisé en ce que, immédiatement avant l'étape de dépôt, on nettoie et/ou on avive ladite surface d'une manière adaptée pour obtenir ladite jonction au moins partielle d'épitaxie.

15. Procédé selon la revendication 14 caractérisé en ce que l'étape de nettoyage et/ou d'avivage est réalisée par bombardement d'ions de gaz neutre.

16. Installation de revêtement pour l'obtention d'une tôle selon les revendications 1 à 10, susceptible d'être utilisée au moins dans l'étape d'application du revêtement du procédé selon l'une quelconque des revendications 11 à 15, comprenant, si A désigne le chrome et si B désigne le zinc :
- des moyens de défilement de la tôle à revêtir face à une fenêtre d'évaporation ou de sublimation d'élément A et/ou B,
- une source d'évaporation ou de sublimation (1) d'élément A et une source d'évaporation ou de sublimation (2) d'élément B disposés successivement sur une direction parallèle à celle dudit défilement et dans le sens de ce défilement, de manière à émettre au travers de la même fenêtre selon un angle utile d'émission limité par ladite fenêtre,
la tôle à revêtir défilant d'un bord d'entrée (3) vers un bord de sortie (4) de ladite fenêtre,
caractérisée en ce qu'elle comprend des moyens pour diminuer l'angle d'émission de la source (2) d'élément B en deçà de la limite représentée par le bord d'entrée (3), lesdits moyens pour diminuer l'angle d'émission de la source (2)
étant montés mobiles en translation perpendiculaire au défilement de la tôle, leur position pouvant varier entre la source (1) d'élément A et la source (2) d'élément B de manière à obtenir soit le revêtement de type -A-AB-A, soit de type-B-AB-B.

17. Installation selon la revendication 16 caractérisée en ce qu'elle comprend également des moyens pour diminuer l'angle d'émission de la source (1) d'élément A en deçà de la limite représentée par le bord de sortie (4) , la position desdits moyens pouvant varier entre la source (1) d'élément A et la source (2) d'élément B de manière à obtenir soit le revêtement de type -A-AB-A, soit de type -B-AB-B.

18. Installation selon l'une quelconque des revendications 16 à 17 caractérisée en ce que lesdits moyens pour diminuer l'angle d'émission sont formés par au moins un écran (9) disposé entre la source (1) d'élément A et la source (2) d'élément B , la position desdits moyens pouvant varier entre la source (1) d'élément A et la source (2) d'élément B de manière à obtenir soit le revêtement de type -A-AB-A, soit de type -B-AB-B.
